Europäisches Patentamt

European Patent Office

Office européen des brevets

(19)

(11) **EP 0 986 178 A2**

(12) **EUROPEAN PATENT APPLICATION**

(43) Date of publication:
**15.03.2000 Bulletin 2000/11**

(51) Int Cl.⁷: **H03L 7/195**

(21) Application number: **99305187.9**

(22) Date of filing: **01.07.1999**

| | |
|---|---|
| (84) Designated Contracting States:<br>**AT BE CH CY DE DK ES FI FR GB GR IE IT LI LU MC NL PT SE**<br>Designated Extension States:<br>**AL LT LV MK RO SI** | (71) Applicant: **Nortel Networks Corporation**<br>**Montreal, Quebec H2Y 3Y4 (CA)** |
| (30) Priority: **17.07.1998 US 118098**<br>**17.07.1998 US 118368**<br>**14.08.1998 US 96692 P** | (72) Inventor: **Faroudi, Navid**<br>**Ottawa, Ontario K1Y 4L9 (CA)** |
| | (74) Representative: **Maury, Richard Philip et al**<br>**Sommerville & Rushton,**<br>**45 Grosvenor Road**<br>**St. Albans, Herts AL1 3AW (GB)** |

(54) **Frequency synthesizer**

(57)     A phase-locked loop (PLL) frequency synthesizer includes a reference divider (RD) and PLL which has a phase/frequency divider (PFD), a charge pump (CP), a voltage control oscillator (VCO) and a feedback divider (FD). The RD's and FD's ratios R and N are varied. In a normal mode, the PFD and the CP cause the VCO frequency to be varied to be locked with a reference frequency. In a speed-up mode, both R and N are divided by the same factor M and the frequency of current generated by the CP is high, resulting in large average CP current and high speed lock acquisition. The R and N return to the original values (the normal mode). The frequency division ratio remains the same.

FIG. 12

**Description**

**Technical Field**

The present invention relates to a phase-locked loop (PLL) frequency synthesizer, a multi-modulus frequency divider and a charge pump circuit.

**Background Information**

A known PLL configuration includes a voltage controlled oscillator (VCO), a phase detector, a charge pump circuit and a loop filter. U.S. Patent 5,675,291 discloses a PLL for use in a frequency synthesizer. A paper by F.M. Gardner entitled "Charge-Pump Phase-Lock Loops", IEEE Transactions on Communications, Vol. COM-28, No. 11, November 1980, p. 1849, a paper by D.-K. Jeong et al entitled "Design of PLL-Based Clock Generation Circuits", IEEE Journal of Solid-State Circuits, Vol. SC-22, No. 2, April 1987, p. 255, and a paper by I.A. Young et al entitled "A PLL Clock Generator with 5 to 110 MHz of Lock Range for Microprocessors", IEEE Journal of Solid-State Circuits, Vol. 27, No. 11, November 1992, p. 1599 describe another type of PLL which comprises a charge pump and a sequential logic phase/frequency detector.

Giga Hertz range frequency synthesizers using a PLL need high-speed multi-modulus frequency dividers which divide input frequency by a selected one of a plurality of division ratios. In a known high-speed multi-modulus frequency divider, an input division ratio N is applied to a decoder having a look-up table which provides appropriate values M and K, so that values M and K are programmably set to the M and K programmable counters, respectively. Because of high input frequency (e.g., GHz range), it requires high speed circuits of bipolar transistors, resulting in a large amount of power consumption.

Charge pump circuits used in frequency synthesizers are described in U.S. Patents 5,675,291 and 5,334,951. In the charge pump circuit, the VCO output frequencies are controllably varied and different frequencies require different charge pump circuit output voltages. The source and sink currents are required to be matched to each other at any voltage of the charge pump circuit output. Although the charge pump circuit is designed to have high output impedances to minimize the mismatch, it is difficult to have infinite output impedances and the mismatch is imminent. Any mismatch between the source and sink currents causes undesirable sidebands at the output of the PLL. In a case of the FETs being CMOS (complementary metal oxide semiconductor) devices, the output impedance of the current sourcing FETs becomes very low to provide low output voltage, or voltages near the positive rail.

**Summary Of The Invention**

It is an object of the present invention to provide improved PLL frequency synthesizer, multi-modulus frequency divider and charge pump circuit.

According to one aspect of the present invention, there is provided a PLL frequency synthesizer for providing a frequency controlled output signal which is phase-locked with a reference signal, the synthesizer comprising: oscillation means for generating the output signal in response to voltage of a frequency control signal fed thereto; first division means for dividing the frequency of the reference signal by a first division ratio and providing a first frequency divided signal, the first division ratio being set in a first mode and decreased in a second mode; second division means for dividing the frequency of the output signal of the oscillation means by a second division ratio and providing a second frequency divided signal, the second division ratio being set in the first mode and decreased in the second mode; and voltage means for generating the frequency control signal in response to the difference in the phase/frequency between the first and second frequency divided signals, the frequency control signal being fed to the oscillation means, so that the frequency of the output signal is varied and the output signal is phase-locked with the reference signal.

In the PLL frequency synthesizer, the voltage means, the oscillation means, the first division means and the second division means form a PLL. In the first mode, the first division means divides the frequency of the reference signal by the first division ratio and provides the first frequency divided signal to the voltage means. The voltage means causes the oscillation means to vary its frequency, so that the frequency controlled output signal is phase-locked with the reference signal. In the second mode, the first and second division ratios are decreased from those of the first mode, so that the frequency of the frequency control signal from the voltage means becomes higher. Therefore, a large frequency control signal is provided to the oscillation means, resulting in high speed lock acquisition. Upon return to the first mode, the PLL frequency synthesizer operates with the original division ratios in the first mode.

According to another aspect of the present invention, there is provided a multi-modulus frequency divider comprising: a dual-modulus counter responsive to an input signal and for providing an output, the dual-modulus counter dividing the frequency of the input signal by either of division ratios P and P+1, P+1 being a power of two, the output having a divided frequency; binary counting means responsive to the output from the dual-modulus counter, the binary counting means providing binary data representing the counting status thereof; data comparison means for comparing binary data representing an input division ratio to the binary data representing the counting status of the binary counting means; and selection means for selecting the division ratio of the dual-modulus counter in response to the comparison result of the data comparison means.

In the multi-modulus frequency divider, the dual-modulus counter divides the input frequency by the selected division ratio P or P+1. The divided frequency is counted by the binary counting means and the binary data representing the counting status is provided to the data comparison means. In response to the comparison result of the data comparison means, the division ratio of the dual-modulus counter is selected. The multi-modulus frequency divider requires no decoder having a look-up table. Also, because the division ratio P+1 of the dual-modulus counter is a power of two, no additional counting circuit (e.g., a flip-flop) is necessary for the high frequency input stage of the dual-modulus counter. Accordingly, the multi-modulus frequency divider consumes less power and its circuitry is less complicated.

For example, the binary counting means includes an m-bit binary counter. The data comparison means separates the binary data of the input division ratio into first binary data of m-bits representing a first value and second binary data of k-bits representing a second value. The complements of the second binary data are provided. The m-bit binary data representing the counting status is compared to the first binary data of m-bits representing the first value and the k LSBs of the m-bit binary data representing the counting status is compared to the complements of the second binary data.

For example, the dual-modulus counter is constructed with bipolar transistor devices and the binary counting means including m-bit binary counter is constructed with CMOS (complementary metal oxide semiconductor) devices. The bipolar transistor devices and the CMOS devices are implemented in a BiCMOS (bipolar-complementary metal oxide semiconductor) circuits. Because the division ratio P+1 of the dual-modulus counter is a power of two, no additional bipolar flip-flop consuming power is necessary for the high frequency input stage of the dual-modulus counter.

According to another aspect of the present invention, there is provided a charge pump circuit comprising a current mirror for sourcing current to and sinking current from an external circuit and control means for controlling current flowing in the current mirror, the current mirror comprising: first transistor means comprising first and second transistors, each having an input control electrode and other two electrodes, the other two electrodes of both transistors being connected in series; and second transistor means comprising third and fourth transistors, each having an input control electrode and other two electrodes, the other two electrodes of both transistors being connected in series, the second transistor means sourcing current to and sinking current from the external circuit, the control means comprising: first transistor control means for providing a first signal to the input control electrode of the first transistor in response to a difference between first and second voltages from the first and second transistor means; second transistor control means for providing a second signal to the input control electrode of the second transistor in response to a reference voltage; and signal input means for feeding the first and second signals to the input control electrodes of the third and fourth transistors in response to a control signal.

The first transistor control means responses to the difference between the first and second voltages and provides the first signal to the first transistor. In the series-connected first and second transistors of the first transistor means, current flows in response to the reference voltage and the first signal. Current flowing in the second transistor means is mirrored current which is proportional to the current flowing in the first transistor means. The mirrored current is sourcing current from the second transistor means to the external circuit connected to the charge pump circuit, or is sinking current from the output circuit to the second transistor means. Because the source and sink currents depend upon the voltage difference between the first and second transistor means, mismatch between the source and sink currents is reduced.

For example, the first transistor control means comprise an operational amplifier. Its non-inverting and inverting input terminals are connected to the junction of the first and second transistors and the junction of the third and fourth transistors. The voltage difference between the two junctions is detected by the operational amplifier and the first signal is provided from the output terminal of the operational amplifier. Because the operational amplifier has a large impedance, a large and definite impedance is presented at the charge pump circuit when current sourcing and sinking. The first voltage is variably controlled in response to the first and second signals so that the first voltage matches the second voltage and hence, the mismatch of source and sink currents is reduced at any output voltage of the charge pump circuit.

According to another aspect of the present invention, the charge pump circuit comprises start-up means for initializing the first transistor means. For example, the first transistor is turned-on with initialization and a start-up current flows in the first transistor means. Once initialized, the charge pump circuit operates in current source and sink modes.

**Brief Description Of The Drawings**

Embodiments of the present invention will now be described by way of example with reference to the accompanying drawings in which:

Figure 1 is a block diagram of a known PLL frequency synthesizer;

Figure 2 illustrates typical PLL loop gain as a function of frequency;

Figure 3 illustrates a charge pump output of the PLL of Figure 1 with phase errors in normal and speed-up modes;

Figure 4 is a block diagram of a PLL frequency synthesizer according to an embodiment of the present invention;

Figure 5 is a block diagram of a programmable dual-modulus divider shown in Figure 4;

Figure 6 is a block diagram of an accumulator shown in Figure 5;

Figure 7 is a block diagram of another programmable dual-modulus divider shown in Figure 4;

Figure 8 is a block diagram of an accumulator shown in Figure 7;

Figure 9 is a block diagram of a programmable dual-modulus counter shown in Figure 5;

Figure 10 is a block diagram of a programmable dual-modulus counter shown in Figure 7;

Figure 11 illustrates a charge pump output of the PLL of Figure 4;

Figure 12 is a block diagram of a multi-modulus frequency divider according to an embodiment of the present invention;

Figure 13 is a block diagram of a 3-bit comparator used in the multi-modulus frequency divider shown in Figure 12;

Figure 14 illustrates binary counter states;

Figure 15 is a block diagram of a multi-modulus frequency divider according to another embodiment of the present invention;

Figure 16 is a block diagram of a multi-modulus frequency divider according to another embodiment of the present invention;

Figure 17 is a schematic diagram of a charge pump circuit according to an embodiment of the present invention; and

Figure 18 is a schematic diagram of a charge pump circuit according to another embodiment of the present invention.

**Detailed Description**

I. PLL Frequency Synthesizer

I-1. Prior Art

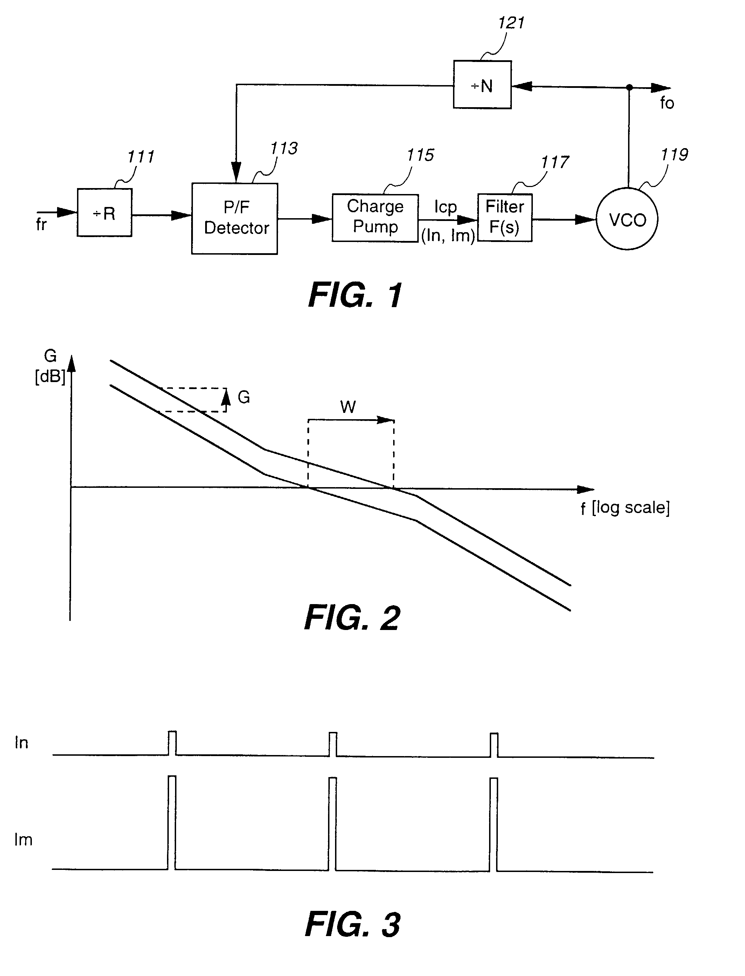

Figure 1 shows a prior art PLL frequency synthesizer including a reference divider (RFD) 111 having a frequency division ratio R, a phase/frequency detector (PFD) 113, a charge pump (CP) circuit 115, a loop filter 117, a voltage-controlled oscillator (VCO) 119 and a feedback divider (FBD) 121 having a frequency division ratio N. A reference signal of a frequency fr is applied to the RFD 111 which provides a frequency divided signal to the PFD 113. An output signal of the VCO 119 is applied to the FBD 121 which provides a frequency divided signal to the PFD 113. In response to the differences in phase and frequency between its two frequency divided signals, the PFD 113 provides an input to the CP circuit 115. The CP circuit 115translates the PFD output pulses to current pulses that are applied to the filter 117. An output signal of the filter 117 drives the VCO 119. A negative feedback exists in the loop. The negative feedback adjusts the VCO frequency fo, so that the two input signals to the PFD 113 have the same frequency and phase and the PLL is "locked". When the PLL is locked, the frequency relationship can be presented as

$$fo/N = fr/R \qquad\qquad (1)$$

or

$$fo = N \times fr/R \qquad\qquad (2)$$

The reference signal is generated by a crystal oscillator (not shown) and has a constant frequency fr. The frequency fo of the PLL output signal is controlled by changing the division ratios N and R of the dividers 111 and 117. When N or R is changed, the PLL requires some time to lock to a new output frequency. This time is directly related to the PLL loop bandwidth. A wider bandwidth results in a faster loop.

One way to achieve high-speed frequency switching is to increase loop gain for a PLL with a lead-lag filter and increase the loop bandwidth. Figure 2 depicts increase in loop gain, ∆G, and increase in unity gain bandwidth, ∆W. However, the increased bandwidth has a negative effect on the in-band noise rejection of the PLL. A high loop gain is only required during switching when low-noise performance is not a requirement. After switching, the loop gain can be reduced back to the original value for a low-noise operation. Additional modifications might be necessary to ensure that the increased gain does not cause instability. It is concerned with the way the loop gain is increased.

The loop gain G for a charge pump PLL is given by

$$G = Kpd \times Icp \times F(s) \times Kv/N \qquad (3)$$

where Kpd is the phase comparator gain, Icp is the charge pump current level, F(s) is the filter transfer function and Kv is the VCO gain.

A reported technique for increasing the loop gain is increasing the charge pump current [W.O. Keese, "Dual PLL IC Achieves Fastest Lock Time With Minimal Reference Spurs", RF Synthesizers, pp. 30-38, August 1995] or Icp in Equation (3). For example, the charge pump current Icp provided by the CP circuit 115 is increased as shown in Figure 3. Increased current Im is four times of normal current In. The loop gain corresponding to the charge pump output current Im is four times of the original loop gain corresponding to the charge pump output current In. This requires the use of larger transistors in the CP circuit 115 that can handle the increased current. Larger transistors have drawbacks, because more silicon area is necessary. Larger parasitic capacitances are introduced and result in lower operation speed. Spacing between transistors is increased resulting in worse transistor matching. One limitation of this technique is that if the voltage at the charge pump output is near the positive supply voltage, the instantaneous charge pump source current may not be increased due to the limited supply voltage. Similarly, when the charge pump output voltage is near the negative supply voltage, the instantaneous charge pump sink current may not be increased.

I-2. Embodiment

(A) Structure of the Embodiment

Instead of increasing the charge pump current to increase loop gain, the divider division ratios are decreased. As it can be seen in Equation (3), the loop gain G is increased if the feedback divider's division ratio N is decreased. This can be done using digital, rather than analog, circuitry.

According to Equation (2), changing N forces the PLL to lock to an incorrect frequency. To remedy that, the reference divider division ratio R is also modified by the same ratio. Then, the relationship between the target output frequency and the reference frequency remains the same during and after speed-up.

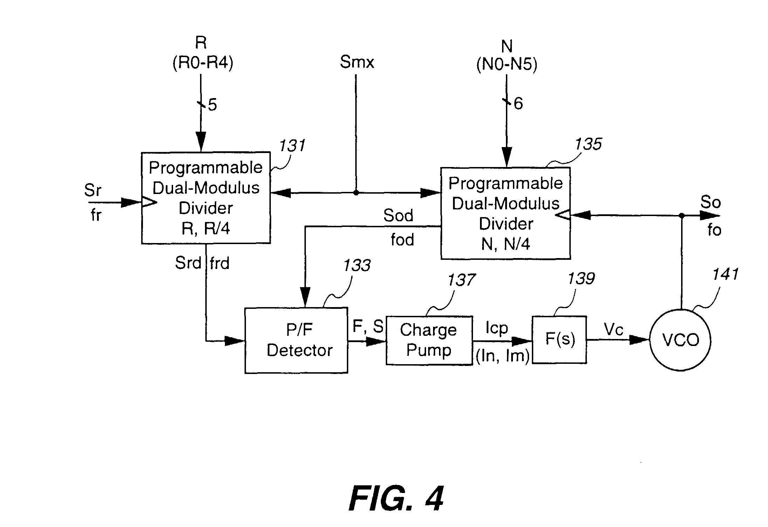

Figure 4 shows a PLL frequency synthesizer according to an embodiment of the present invention. In Figure 4, a reference signal Sr having a frequency fr is fed to a programmable dual-modulus divider (PDMD) 131 which provides an output signal Srd having a frequency frd to a phase/frequency detector (PFD) 133. The PFD 133 also receives a signal Sod from another PDMD 135. The PFD 133 detects the differences in phase and frequency between the signals from the PDMDs 131 and 135 and provides pulse trains F and S. In response to the pulse train F or S, a charge pump (CP) circuit 137 generates source current or sink current Icp. A loop filter 139 converts the current Icp to voltage Vc which controls a frequency generated by a VCO 141 which provides an output signal So of the PLL frequency synthesizer. The signal So is fed to the PDMD 135 which provides the signal Sod to the PFD 133. 5-bit binary data R0-R4 representing a reference value R, 6-bit binary data N0-N5 representing a feedback value N and a single-bit control signal Smx are fed to the PDMD 131, the PDMD 135 and the PDMDs 131 and 135, respectively, by data/signal sources (not shown).

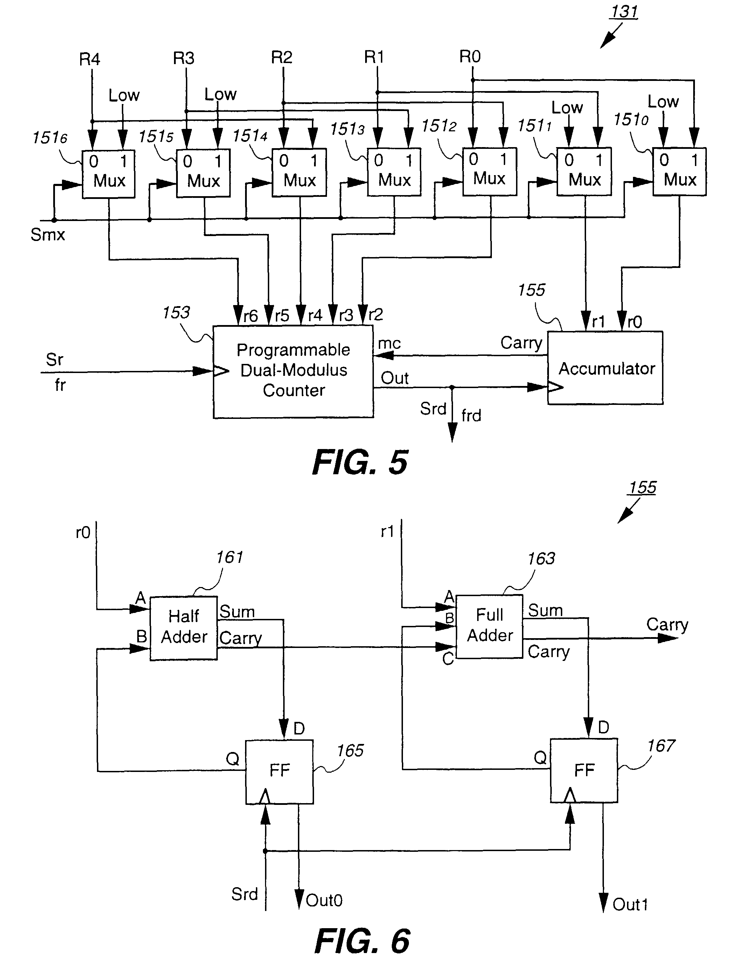

A detail of the PDMD 131 is shown in Figure 5. The PDMD 131 includes seven multiplexers $151_0$-$151_6$, a programmable dual-modulus counter (PDMC) 153 and an accumulator 155. The 5-bits R0-R4 are fed to the "1" inputs of the five multiplexers $151_0$-$151_4$, respectively. A "low" bit is fed to the "1" input of each of the multiplexers $151_5$ and $151_6$. A "low" bit is fed to the "0" input of each of the multiplexers $151_0$ and $151_1$. The 5-bits R0-R4 are fed to the "0" inputs of the five multiplexers $151_2$-$151_6$, respectively. The multiplexers $151_0$-$151_6$ are controlled by the signal Smx. The selected outputs from the multiplexers $151_0$ and $151_1$ are fed to the accumulator 155 as 2-bit data r0 and r1. The selected outputs from the multiplexers $151_2$-$151_6$ are fed to the PDMC 153 as 5-bit modulus data r2-r6.

Figure 6 shows a detailed circuit of the accumulator 155. In Figure 6, the 2-bit data r0 and r1 are fed to a half adder 161 and a full adder 163, respectively. The output signal Srd from the PDMC 153 of Figure 5 is fed to the clock inputs of flip-flops (FFs) 165 and 167, the Q outputs of which are fed to the half adder 161 and full adder 163, respectively. The sum output of the half adder 161 is fed to the D input of the FF 165 and the carry output is fed to the full adder 163. The sum output of the full adder 163 is fed to the D input of the FF 167 and the carry output of the full adder 163 is fed to the PDMC 153.

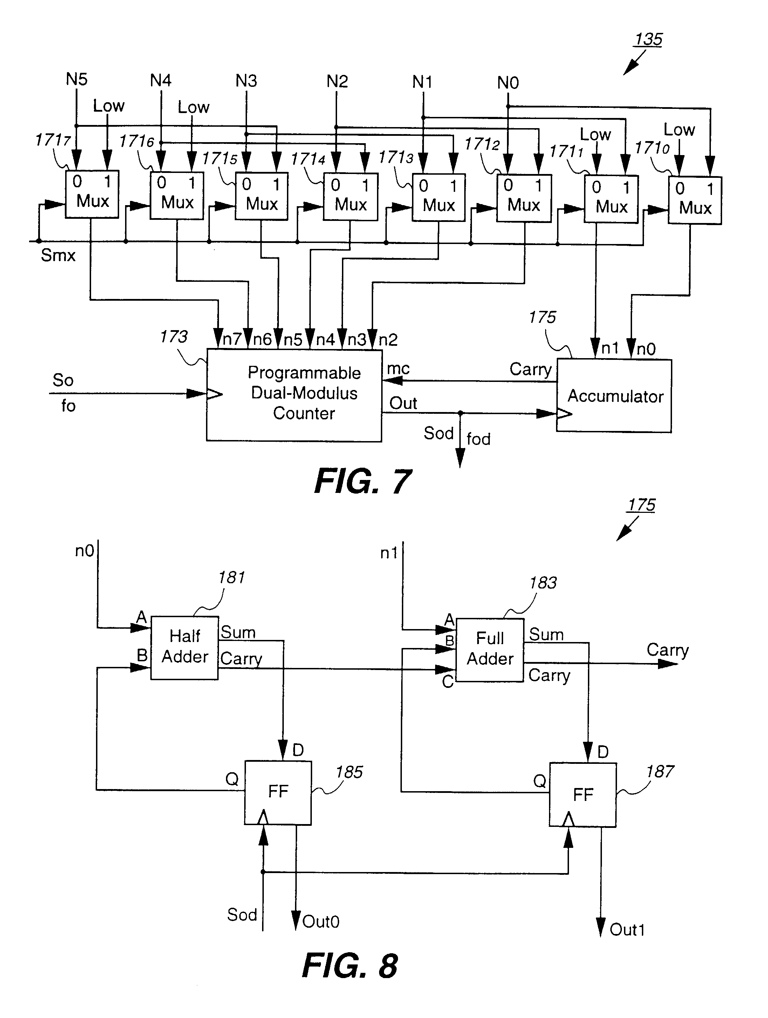

Figure 7 shows the PDMD 135 which has a similar configuration to the PDMD 131. In Figure 7, the PDMD 135 includes eight multiplexers $171_0$-$171_7$, a PDMC 173 and an accumulator 175. The 6-bits N0-N5 are fed to the "1" inputs of the six multiplexers $171_0$-$171_5$, respectively. A "low" bit is fed to the "1" input of each of the multiplexers $171_6$ and $171_7$. A "low" bit is fed to the "0" input of each of the multiplexers $171_0$ and $171_1$. The 6-bits N0-N5 are fed to the "0" inputs of the six multiplexers $171_2$-$171_7$, respectively. The multiplexers $171_0$-$171_7$ are controlled by the signal Smx.

The selected outputs from the multiplexers $171_0$ and $171_1$ are fed to the accumulator 175 as 2-bit data n0 and n1. The selected outputs from the multiplexers $171_2$-$171_7$ are fed to the PDMC 173 as 6-bit modulus data n2-n7.

Figure 8 shows a detailed circuit of the accumulator 175. In Figure 8, the 2-bit data n0 and n1 are fed to a half adder 181 and a full adder 183, respectively. The output signal Sod from the PDMC 173 of Figure 7 is fed to the clock inputs of FFs 185 and 187, the Q outputs of which are fed to the half adder 181 and full adder 183, respectively. The sum output of the half adder 181 is fed to the D input of the FF 185 and the carry output is fed to the full adder 183. The sum output of the full adder 183 is fed to the D input of the FF 187 and the carry output of the full adder 183 is fed to the PDMC 173.

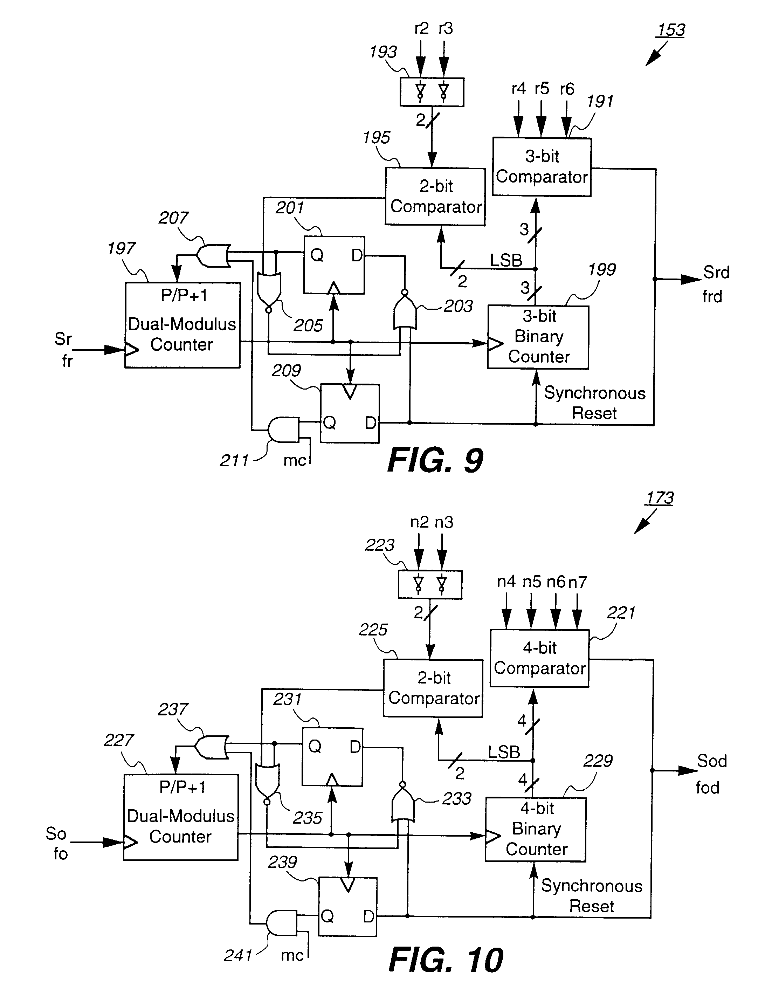

Figure 9 is a block diagram of the PDMC 153 shown in Figure 5. In Figure 9, 3-bit data of r4-r6 is applied to an m-bit comparator 191. 2-bit data of r2 and r3 is applied to inverters 193 and all bits are inverted by the inverters 193 to generate 1's complements. The output data of the inverters 193 is fed to a 2-bit comparator 195. The reference signal Sr clocks a dual-modulus counter 197 which divides the frequency fr. The output of the counter 197 is fed to a 3-bit binary counter 199 and a D-type flip-flop (D-FF) 201. The counter 199 provides 3-bit output to the comparator 191, 2 LSBs (least significant bits) of the 3-bits being fed to the comparator 195. The comparator 191 provides an m-bit comparison result as an output signal Srd of frequency frd which is fed to the counter 199 and a NOR gate 203. The comparator 195 provides a 2-bit comparison result to a NOR gate 205, the output of which is fed to the NOR gate 203. The output of the NOR gate 203 is fed to the D input of the D-FF 201, the Q output of which is fed to the NOR gate 205 and an OR gate 207. The output of the OR gate 207 is fed to the counter 197. The output of the counter 197 is also fed to the clock input of a D-FF 209. The output of the comparator 191 is fed to the D input of the D-FF 209, the Q output of which is fed to an AND gate 211. The carry output of the accumulator 155 shown in Figure 5 is fed to the AND gate 211, the output of which is fed to the OR gate 207. In response to the output of the OR gate 207, the counter 197 selects either of two division ratios P and P+1. P+1 is a power of 2 ($P+1=2^2$). The output signal Srd of the comparator 191 is fed to the counter 199 for a synchronous reset.

Figure 10 is a block diagram of the PDMC 173 shown in Figure 7. The PDMC 173 includes a 4-bit comparator 221 and a 4-bit binary counter 229 and other circuit blocks are the same as those of the PDMC 153 shown in Figure 9. In the Figure 10, 4-bit data of n4-n7 is applied to the 4-bit comparator 221 and 2-bit data of n2 and n3 is applied to inverters 223. The reference signal So is fed to a dual-modulus counter 227 which divides the frequency fo. The output of the counter 227 is fed to the 4-bit binary counter 229 and D-FFs 231 and 239. The counter 229 provides a 4-bit output to the comparator 221, 2 LSBs of the 4-bits being fed to a 2-bit comparator 225. The comparison output of the comparator 225 and the Q output of the D-FF 231 are fed to a NOR gate 235, the output of which is fed to a NOR gate 233. The comparator 221 provides a 4-bit comparison result as an output of frequency fod which is fed to the counter 229, the NOR gate 233 and the D-FF 239. The Q output of the D-FF 239 and the carry output of the accumulator 175 shown in Figure 7 are fed to the AND gate 241, the output of which is fed to the OR gate 237. The output of the OR gate 237 is fed to the counter 227.

(B) Operation of the Embodiment

The controlled values R and N are separately fed. The PLL operates in two modes: normal and speed-up modes. In the speed-up mode, the division ratios of the PDMDs 131 and 135 are divided by the same factor to be reduced.

(a) Normal Mode

The signal Smx is set to "0". The multiplexers $151_0$-$151_6$ of the PDMD 131 and the multiplexers $171_0$-$171_6$ of the PDMD 135 select their "0" inputs. In the PDMD 131, the 5-bit data R0-R4 is fed to the PDMC 153 through the multiplexers $151_2$-$151_6$ as data r2-r6 and "low" data is fed to the accumulator 155 through the multiplexers $151_0$ and $151_1$ as data r0 and r1. The frequency division ratio of the PDMC 153 is set to the value R represented by the 5-bit data R0-R4 and the PDMC 153 counts the reference signal Sr. The frequency fr of the reference signal Sr is divided by R, resulting in the frequency frd of the signal Srd being fr/R. At the same time, in the PDMD 135, the 6-bit data N0-N5 is fed to the 173 through the multiplexers $171_2$-$171_6$ as data n2-n6 and "low" data is fed to the 175 through the multiplexers $171_0$ and $171_1$ as data n0 and n1. The frequency division ratio of the 173 is set to the value N represented by the 5-bit data N0-N4 and the 173 counts the signal So. The frequency fo of the signal So is divided by N, resulting in the frequency fod of the signal Sod being fo/N.

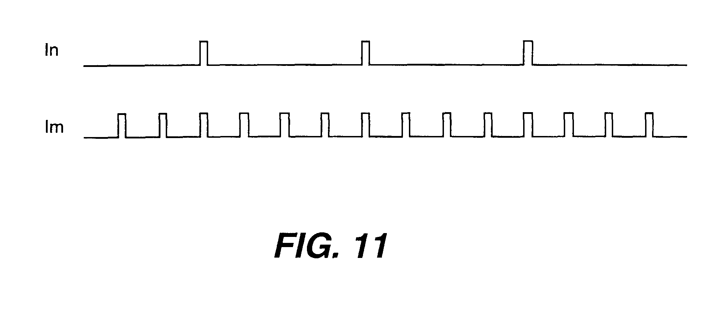

The PFD 133 which receives the signals Srd and Sod detects the difference in the phase/frequency between the two signals Srd and Sod and generates pulse trains F and S. In response to the pulse trains F or S, the CP circuit 137 sources the current Icp to or sinks the current Icp from the filter 139. The filter 139 provides the voltage Vc to the VCO 141 to control the frequency fo of the signal So which is fed to the PDMD 135. In the PLL, the pulse trains F and S are generated to match the frequency frd of the signal Srd to that of the signal Sod, resulting in the signal So being locked with the reference signal Sr. In that process of acquiring lock, the current Icp is current In as shown in Figure 11.

<u>(b) Speed-Up Mode</u>

When the value R or the value N or both are varied, the signal Smx is set to "1". In response to switching of the signal Smx from "0" to "1", the multiplexers $151_0$-$151_6$ of the PDMD 131 and the multiplexers $171_0$-$171_6$ of the PDMD 135 to select their "1" inputs. In the PDMD 131, the R data bits R0 and R1 are fed to the accumulator 155 as bits r0 and r1, respectively. The other three bits R2-R4 are fed to the PDMC 153 as bits r2-r4. The "low" bits are fed to the PDMC 153 as bits r5 and r6. Hence, the 5-bit data R0-R4 are shifted by two bits and the resultant average division ratio set in the PDMC 153 is R/4. The average frequency frd of the signal Srd is fr/(R/4).

At the same time, in the PDMD 135, the 6-bit data N0-N5 is shifted by two bits and the average division ratio of the 173 is N/4. The average frequency fod of the signal Sod is fod/(N/4). Hence, the frequency in the PLL becomes four times higher than the normal mode and the frequency of the current Icp provided by the CP circuit 137 is also four times higher. The frequency fo of the signal So does not become higher, because both division ratios R and N are reduced by the same number (=4) at the same time. The current Icp increases its frequency as Im shown in Figure 11.

In the embodiment, the division ratios R and N of the PDMDs 131 and 135 each have minimum values Rmin and Nmin. The divided resultants of the values R and N by the same factor (in the above case, four) must be equal to or greater than the minimum values Rmin and Nmin. Note that the division factor is not limited to four. For example, by using 3-bit accumulators, a division factor of 8 can be achieved.

The loop gain corresponding to the charge pump output current Im in the speed-up mode is four times of the original loop gain corresponding to the charge pump output current In. It can be seen in Figures 2 and 11 that the average charge pump output current is the same for the two cases. In the embodiment, the frequency of the current Im is four times of that of the current In, the amplitude of the current Im is equal to the original current In. Therefore, the current Im does not saturate due to the supply voltage of the CP circuit 137.

In the accumulator 155 or 175, every time the accumulator has a carry output, it forces the PDMC 153 or 173 to divide by N+1. The average division ratio of DMD is N+F/2m, where F is the input to the accumulator and m is the number of bits in the accumulator (in the case of the shown example m=2) [U.L. Rohde et al., Communications Receivers: Principles & Design (Mc Graw-Hill 1988)], p. 308].

The signal Smx returns from "1" to "0", so that the multiplexers $151_0$-$151_6$ of the PDMD 131 and the multiplexers $171_0$-$171_6$ of the PDMD 135 set their inputs to "0". Thereafter, the PDMDs 131 and 135 operate as the normal mode and the current Icp generated by the CP circuit 137 is current In shown in Figure 11.

Phase error is produced at the output of a frequency divider when performing fractional division. In each cycle, the division ratio of the divider is either N or N+1 while the average division ratio is a fractional number between N and N+1. This causes instantaneous phase error to exist between the divider output and an ideal fractional divider. This phase error is detected by the phase comparator which in turn modulates the VCO 141. Sidebands, referred to as fractional spurs, appear in the spectrum of the synthesizer output.

In the PLL synthesizer, according to the embodiment, fractional spurs are produced during speed-up. After the speed-up is over, the division ratios are changed back to their original integer values returning the synthesizer to its low-noise performance.

<u>II. Multi-Modulus Frequency Divider</u>

Synthesizers use multi-modulus frequency divider. In a known high-speed multi-modulus frequency divider, an input division ratio N is applied to a decoder having a look-up table which provides appropriate values M and K, so that values M and K are programmably set to the M and K programmable counters, respectively. A dual-modulus counter (DMC) divides input frequency fin and its output of a divided frequency is provided to the K and M counters. The DMC selects its division ratio P or P+1 in response to the count of the K counter. Value K is any value between 0 to P-1. If value K is greater than zero, the division ratio of the DMC is set to P+1 at the start of the cycle. The divided output of the DMC clocks the two counters. When the count of the K counter reaches its programmed value K, it ceases counting and the division ratio of the DMC is set to P. When the count of the M counter reaches its programmed value M, the M and K counters are reset and the cycle repeats. A divided frequency fout is provided by the M counter. A total division ratio Rdiv of the frequency divider is given by:

$$Rdiv = fin/fout = K(P+1) + (M-K)P$$

or

$$Rdiv = fin/fout = MP + K \qquad (4)$$

A drawback is that it requires the decoder which needs a great number of input bits, resulting in a complicated circuit. For example, the frequency divider needs a large number of bits to divide numbers as high as 262,143. Specifically, the decoder needs 18 input bits. One solution is to choose P equal to a power of two ($P=2^k$). The total division ratio Rdiv of the frequency divider is given by:

$$Rdiv = fin/fout = M(2^k) + K \qquad (5)$$

Because the k least significant bits (LSBs) of the input division ratio word can be directly used as the program inputs to the K counter and the remaining bits of the input word can be directly used as the program input to the M counter, no decoder is required. The largest modulus of a counter with n flip-flops is $2^n$. In order to count to $2^{n+1}$, an additional flip-flop is necessary for the input stage of the counter, the additional flip-flop being clocked with a high input frequency. Because of high input frequency (e.g., GHz range), it requires high speed circuits of bipolar transistors, resulting in a large amount of power consumption. This is a drawback of the DMC having division ratios of P/P+1, P being a power of two ($P=2^k$).

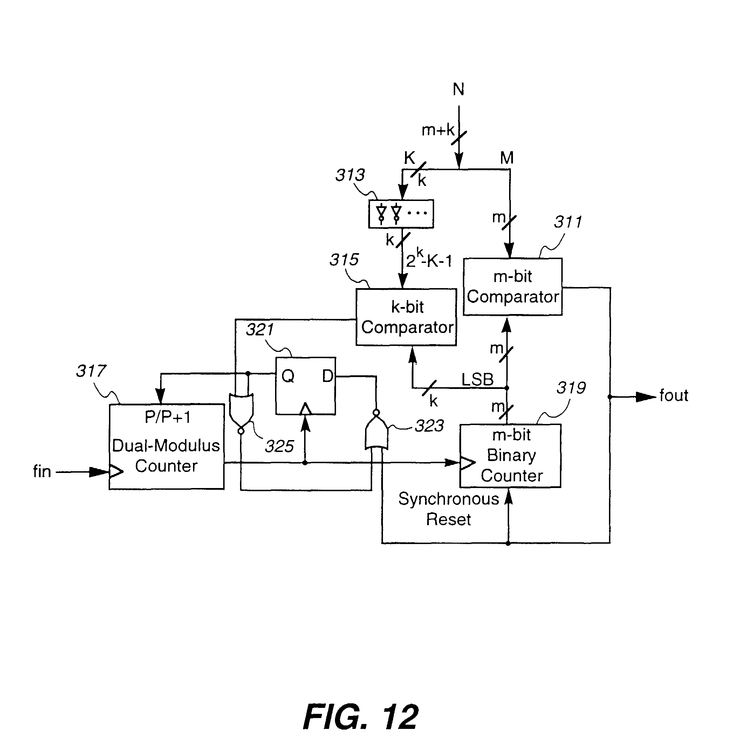

Figure 12 shows a multi-modulus frequency divider according to an embodiment of the present invention. In Figure 12, an input division ratio N is programmably given as binary data by an external circuit (not shown). The data of ratio N includes m-bit data of value M and k-bit data of value K. The m-bit data and k-bit data are separated and thereafter applied to an m-bit comparator 311 and inverters 313, respectively. All bits of the k-bits of value K are inverted by the inverters 313 to generate 1's complements of value K. The output data of the inverters 313 is k-bit data representing $2^k$-K-1 and is fed to an k-bit comparator 315.

An input signal of frequency fin clocks a dual-modulus counter (DMC) 317 which divides the frequency fin. The output of the counter 317 is fed to a m-bit binary counter 319 and a D-type flip-flop (D-FF) 321. The counter 319 provides m-bit output to the comparator 311, k LSBs (least significant bits) of the m-bits being fed to the comparator 315. The comparator 311 provides an m-bit comparison result as an output of frequency fout which is fed to the counter 319 and a NOR gate 323. The comparator 315 provides an k-bit comparison result to a NOR gate 325, the output of which is fed to the NOR gate 323. The output of the NOR gate 323 is fed to D input of the D-FF 321, the Q output of which is fed to the NOR gate 325 and the counter 317. In response to the Q output of the D-FF 321, the counter 317 selects either of two division ratios P and P+1. P+1 is a power of two ($P+1=2^k$).

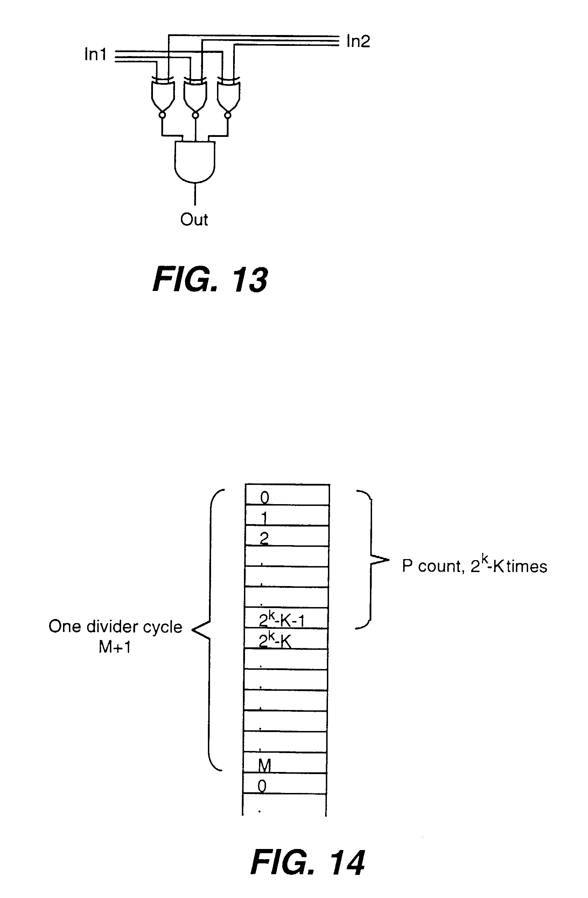

An example of the m-bit and k-bit comparators 311 and 315 is a 3-bit comparator shown in Figure 13. It includes three exclusive NOR (XNOR) gates and an AND gate. Each data bit of one input $In_1$ is fed to the one input terminal of each XNOR gate and each data bit of the other input $In_2$ is fed to the other input terminal of each XNOR gate. The outputs of the three XNOR gates are fed to the AND gate, the "1" and "0" outputs of which represents the two inputs being identical and not.

When the m-bits of the output of the counter 319 match the m-bits of value M, the AND gate of the comparator 311 produces the "1" output. Similarly, when the k-bits of the output of the converter 313 match the k LSB bits of the counter 319 output, the AND gate of the k-bit comparator produces the "1" output.

The reset input of the counter 319 is synchronous. Therefore, when the counter 319 reaches M, it is reset on the next rising edge at the output of the counter 317. Since the counter 319 also counts 0 in the count sequence, it has a modulus of M+1. In other words, there are (M+1) DMC cycles in one divider cycle. The output of the comparator 311 is used as the output of the multi-modulus frequency divider.

When the cycle starts and the counter 319 is in count 0, the counter 317 counts to P. When the k LSBs of the counter 319 output reach $2^k$-K-1, the D-FF 321 is set on the next rising edge of the counter 317 output. That sets the counter 317 to P+1. Thus, the number of times the counter 317 counts to P, in each cycle, is equal to $2^k$-K. This is demonstrated in Figure 14.

For the rest of the time, during each cycle, the counter 317 is set to P+1. Value K may be any value in the inclusive range of 0 to $2^k$-1. In a case of K being 0, the counter 317 counts $2^k$ times to P in each cycle. In a case of K being $2^k$-1, the counter 317 counts only once to P in each cycle.

When the counter 319 reaches M, the counter 319 and the D-FF 321 are reset on the next rising edge at the output of the counter 317, and the cycle repeats. Therefore, the total division ratio Rdiv of the divider is given by:

$$\mathrm{Rdiv} = \mathrm{fin}\,/\,\mathrm{fout} = (2^k\text{-}K)P + (M\text{+}1\text{-}2^k\text{+}K)(P\text{+}1)$$

$$= M(P\text{+}1)\text{+}K\text{+}\ P\text{+}1\text{-}2^k \qquad\qquad (6)$$

Because P+1 is $2^k$, the division ratio Rdiv is simplified to:

$$\mathrm{Rdiv} = \mathrm{fin/fout} = M(P\text{+}1) + K \qquad\qquad (7)$$

or

$$\mathrm{Rdiv} = \mathrm{fin/fout} = M(2^k) + K \qquad\qquad (8)$$

Therefore, the multi-modulus divider shown in Figure 12 does not need a complicated look-up table and the K counter included in the known high-speed multi-modulus frequency divider is eliminated.

Typically, the multi-modulus frequency divider is implemented in a BiCMOM device. The counter 317 is constructed with bipolar transistor devices and the m-bit binary counter 319 is constructed with CMOS (complementary metal oxide semiconductor) devices. Because the division ratio P+1 of the DMC 317 is a power of two, no additional bipolar flip-flop consuming power is necessary for the high frequency input stage of the counter 317.

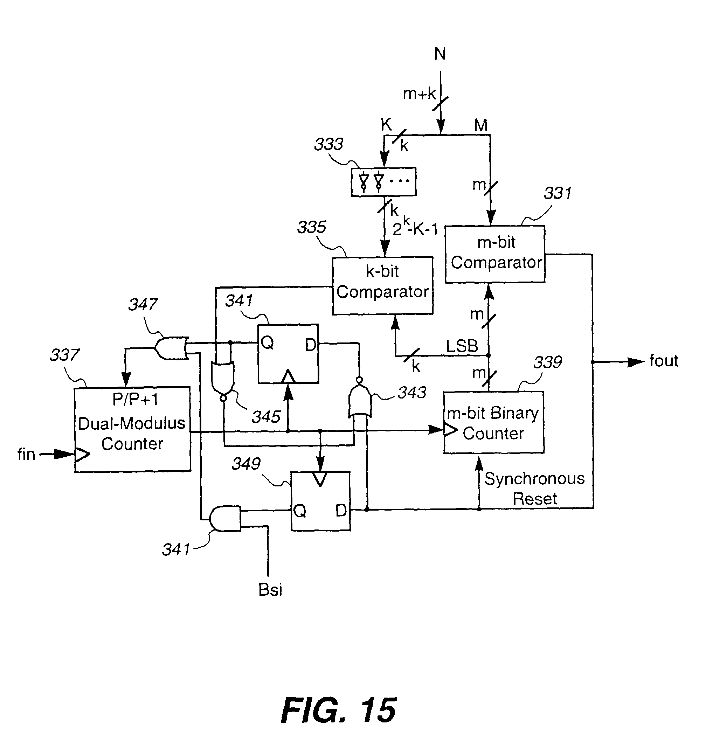

Figure 15 is a block diagram of a multi-modulus frequency divider according to another embodiment of the present invention. In Figure 15, a programmable division ratio N represents values M and K by m and k bits, respectively. The m and k bits of ratio N are applied to an m-bit comparator 331 and inverters 333, respectively. All bits of value K are inverted (1s complement) and k bits representing $2^k$-K-1 are fed to a k-bit comparator 335.

An input signal of frequency fin clocks a DMC 337 which divides the frequency. The output of the counter 337 is fed to a m-bit binary counter 339 and the clock input of a D-FF 341. The counter 339 provides m-bit output to the comparator 331, k LSBs of the m-bits being fed to the comparator 335. The comparator 331 provides an m-bit comparison result as an output of frequency fout which is fed to the counter 339 and a NOR gate 343. The comparator 335 provides a k-bit comparison result to a NOR gate 345, the output of which is fed to the NOR gate 343. The output of the NOR gate 343 is fed to the D input of the D-FF 341, the Q output of which is fed to the NOR gate 345 and an OR gate 347. The output of the OR gate 347 is fed to the counter 337. The output of the counter 337 is also fed to the clock input of a D-FF 349. The output of the comparator 331 is fed to the D input of the D-FF 349, the Q-output of which is fed to an AND gate 351. Additional single bit Bsi is fed to the AND gate 351, the output of which is fed to the OR gate 347.

The differences between the multi-modulus frequency divider shown in Figures 15 and 12 are that the former includes the OR gate 347, the D-FF 349 and the AND gate 351. The structure and function of the circuits common to both multi-modulus frequency dividers are identical.

In response to the Q output of the D-FF 341, the counter 337 selects either of two division ratios P and P+1. P+1 is a power of two ($P+1=2^k$).

In a case of the single bit Bsi being logic "0", the output of the AND gate 351 is "0" and the OR gate 347 forwards the output of the D-FF 341 to the P/P+1 control input of the counter 337. In this case, the circuit operates in the same manner as the circuit of Figure 12 (i.e., N-divider).

In a case of the single bit being logic "1", when the counter 339 is in the 0 state (see Figure 14), the output of the AND gate 351 is "1" which is transferred to the P/P+1 control input of the counter via the OR gate 347. In this case, the DMC 337 is forced to count to P+1 for one additional state per cycle. The result is that the division ratio of the multi-modulus divider is increased by 1 (i.e., (N+1)-divider). This type of divider can be used for fractional division around a programmable integer division ratio N.

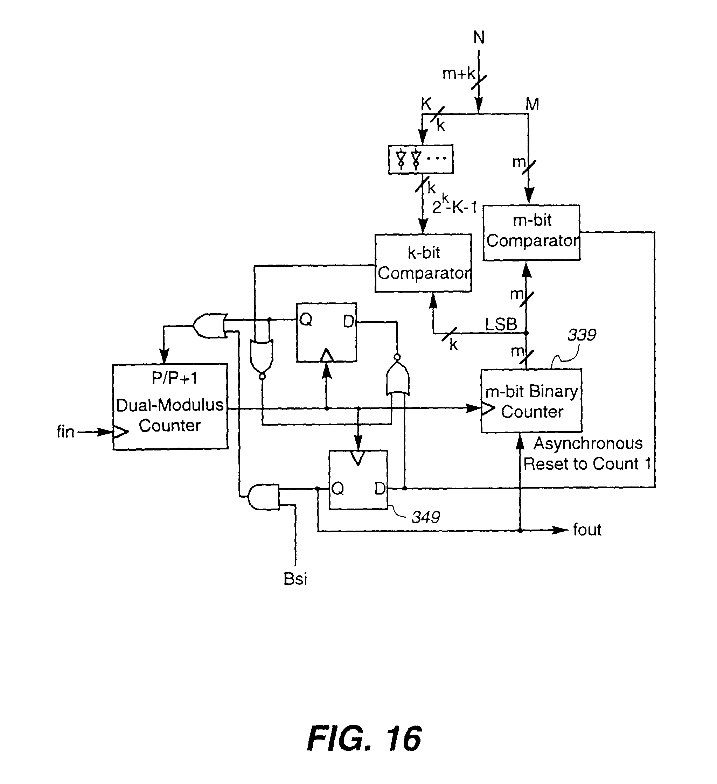

Figure 16 is a block diagram of a multi-modulus frequency divider according to another embodiment of the present invention. The divider shown in Figure 16 is a minor modification of the divider shown in Figure 15. In Figure 16, the m-bit counter has an asynchronous reset. The output of the divider is provided from the Q output of the D-FF 349. Also, the output is fed to the counter 339 to achieve a synchronous reset. The retiming function is performed by the D-FF 349. The counter 339 remains as long as the reset signal input thereto is "1", because the counter reset is asynchronous. This causes the counter 339 to divide by M+2. When the counter 339 receives a "high" reset input signal, it is reset to count 1, instead of count 0, with the result that the counter 339 divides by M+1.

III. Charge Pump Circuit

III-1. Prior Art

As shown in Figure 1, the CP circuit 115 is included in the PLL having the PFC 113, the loop filter 117, the VCO 119 and the FBD 121 having a frequency division ratio N. A reference signal of a frequency fr is fed to the PFC 113. An output signal of the VCO 119 is fed to the FBD 121 which provides a frequency divided signal to the PFC 113. In response to the differences in phase and frequency between the reference signal and the divided signal, the PFC 113 provides an input (an up signal UP or a down signal DN) to the CP circuit 115. The CP circuit 115 translates the PFC output pulses to current pulses that are fed to the filter 117. An output signal of the filter 117 drives the VCO 119. A negative feedback exists in the loop. The negative feedback adjusts the VCO frequency fo, so that the two input signals to the PFC 113 have the same frequency and phase, so that the PLL is "locked". The CP circuit 115 operates as a current source of current Iso and a current sink of current Isi, in response to the up signal UP and the down signal DN, respectively.

When the CP circuit 115 is locked, both and sink current flow for a short period of time in each cycle in order to avoid a dead zone [U.S. Patent 4,814,726]. If there is no leakage at the charge pump circuit output, the source and sink currents will be perfectly matched. Such ideal source and sink current pulses result in a spur-free synthesized output from the VCO 119. If there is a leakage at the output of the CP circuit 115, the PLL negative feedback adjusts the turn-on times of the sink and source currents with respect to each other, so that the average charge pump output voltage remains constant. The source and sink current pulses must terminate simultaneously. If a time difference exists between the termination time of the source and sink currents, the PLL feedback enforces a time differences in the initialization of the two currents to keep the average VCO input voltage constant.

The source and sink currents should have identical amplitudes. If there is a mismatch, the PLL feedback causes a mismatch in the initiation time of the two currents to keep the average VCO control voltage constant. When the PLL is locked, any of the previously mentioned imperfections, or a combination of them, causes an ac component with a frequency of fr to appear at the output of the CP circuit 115. The ac component frequency modulates the VCO. The bandwidth of the filter 117 can be reduced to attenuate the ac component. However, this would have a negative effect on the switching speed of the PLL. Therefore, it is necessary to minimize the leakage and the timing and amplitude mismatch between the source and sink current pulses in the CP circuit 115.

Any current source has a finite output impedance. The sink and source currents in a charge pump circuit are generated by current sources. The voltage across the sink current source is the charge pump output voltage. The source voltage is the supply voltage minus the charge pump voltage. When a PLL is locked, the voltage at the output of the charge pump depends on the synthesized VCO output frequency. The mismatch between the sink and source current amplitudes depends on the charge pump voltage. The reference feedthrough is worse for the charge pump voltages that are near 0 or the positive supply voltage. Although the charge pump voltage, in general, can be any value between 0 and the supply voltage, only a portion of this range results in acceptable levels of reference feedthrough. The PLL operation must be limited to acquire a charge pump voltage away from the rails. The acceptable amount of reference feedthrough puts a limit on the range of voltage that can exist at the charge pump output. This puts a limit on the range of frequencies that can exit at the output of a given VCO. Therefore, it is required to maximize the voltage range at the charge pump output in which the mismatch is acceptable.

Cascode FET current sources used in charge pump circuits provides higher output impedances. However, cascode current sources have a high compliance voltage. That cannot be tolerated in low-voltage applications [F. You et al, "An Improved Tail Current Source for Low Voltage Applications," IEEE J. Solid-State Circuits, Vol. 32, No. 8, August 1997, pp. 1173-1180].

III-2. First Embodiment

(A) Structure of the First Embodiment

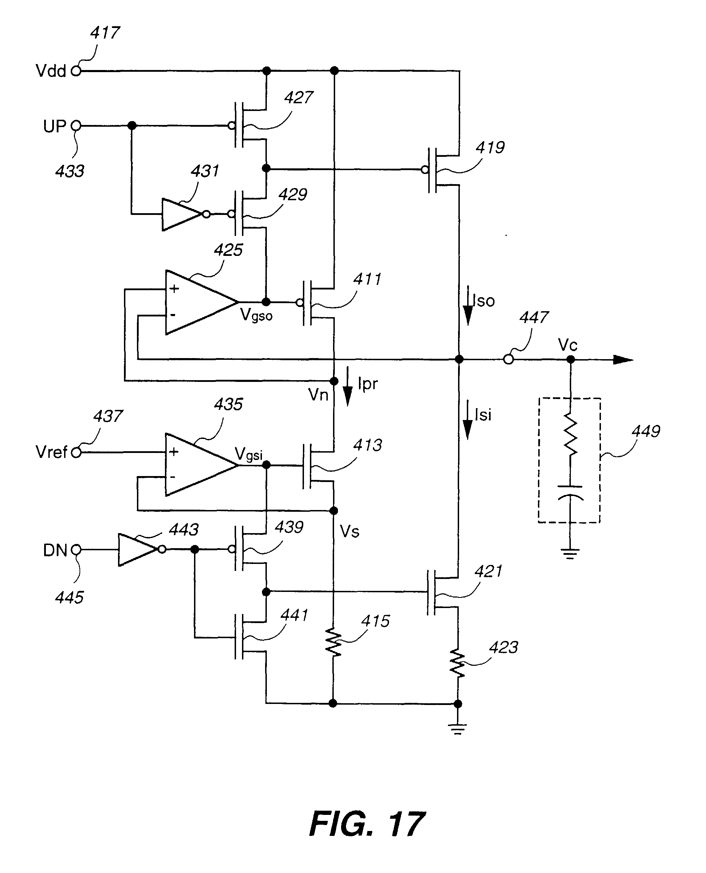

Figure 17 shows a charge pump (CP) circuit according to one embodiment of the present invention. In Figure 17, the source-drain of a P-channel FET 411, the drain-source of an N-channel FET 413 and a resistor 415 are connected in series between a terminal 417 of supply voltage Vdd (e.g., +3.3 volts) and the ground terminal. Also, the source-drain of a P-channel FET 419, the drain-source of an N-channel FET 421 and a resistor 423 are connected in series between the terminal 417 and the ground terminal. The junction of the drains of the FETs 411 and 413 and the junction of the drains of the FETs 419 and 421 are connected to the non-inverting and inverting input terminals of a MOS operational amplifier 425, the output terminal of which is connected to the gate of the FET 411. Two P-channel FETs 427 and 429 are connected in series between the terminal 417 and the gate of the FET 411. The junction of the drain of the FET 427 and the source of the FET 429 is connected to the gate of the FET 419. An inverter 431 is connected between a signal input terminal 433 and the gate of the FET 429. The gate of the FET 427 is connected to the terminal 433. The source of the FET 413 is connected to the inverting input terminal of a MOS operational amplifier 435, the non-inverting input terminal of which is connected to a terminal 437 of reference voltage Vref. The output terminal of the amplifier 435 and the gate of the FET 413 are connected to the source of a P-channel FET 439, the drain of which is connected to the drain of an N-channel FET 441 and the gate of the FET 421. The source of the FET 441 is connected to the ground terminal. An inverter 443 is connected between a signal input terminal 445 and the gates of the FETs 439 and 441. The junction of the drains of the FETs 419 and 421 is connected to an output terminal 447 which is connected to a loop filter 449 having a capacitor of an external circuit (e.g., the PLL's VCO). The W/L (gate size) ratio of the P-channel FETs 211 and 219 is larger than that of the N-channel FETs 213 and 221.

(B) Operation of the First Embodiment

Pulse trains UP and DN are fed from a phase/frequency comparator (not shown) to the signal input terminals 431 and 445, respectively. The reference voltage Vref is fed to the voltage terminal 437 by a dc supply (not shown). The CP circuit operates in float, current-source and current-sink modes and provides output voltage Vo from the terminal 447 to the external circuit.

In the series-connected FETs 411 and 413, reference current Iref flows in response to the reference voltage Vref. Each of the MOS operational amplifiers 425 and 435 has an infinite input resistance and all of the current Iref flows through the resistor 415. The current flowing in the FET 411 is equal to the current flowing in the FET 413. The current Iref causes a voltage drop Vs across the resistor 415. The amplifier 425 amplifies the voltage difference between the voltage Vn at the junction of the drains of the FETs 411 and 413 and the output voltage Vo, so that a gate voltage Vgso is provided from its output terminal to the gate of the FET 411. Similarly, the amplifier 435 amplifies the voltage difference between the voltages Vref and Vs to provide gate voltage Vgsi to the gate of the FET 413. Accordingly, the current Iref flowing in the series-connected FETs 411 and 413 is also dependent upon the reference voltage Vref. The reference current Iref flowing in the series-connected FETs 411 and 413 is set by the negative feedback provided by the amplifier 435. Due to the high input resistances of the amplifiers 425 and 435, it is assumed that Vs = Vref and Iref = $Vref/R_{415}$. $R_{415}$ is the resistance of the resistor 415.

(i) Current-Sink Mode (Output Decrease Mode)

Where the output voltage Vo is required to decrease, the pulse train DN is fed to the terminal 445 and no pulses UP are fed. During the pulse DN being high, the FETs 439 and 441 are on and off, respectively. The voltage Vgsi, which is an amplified voltage of the voltage difference (Vref - Vs), is fed to the gate of the FET 413 and to the gate of the FET 421 via the on-FET 439. The current Isi flowing in the FET 421 in response to the voltage Vgsi is mirrored (i.e., multiplied) current of the reference current Iref flowing in the FETs 411 and 413. The current Isi is sunk from the filter 449 and discharges the capacitor thereof. Therefore, the output voltage Vo decreases during the pulse DN being high.

The amplifier 435 detects the voltage difference (Vn-Vo) in the current-sink mode. The negative feedback provided by the amplifier 435 guarantees that the voltage Vn is equal to the voltage Vo. The drain-source voltage of the FET 413 is equal to that of the FET 421. Hence, the current Isi flowing in the FET 421 is equal to the current flowing in the current Iref flowing in the FET 413.

(ii) Current-Source Mode (Output Increase Mode)

Where the output voltage Vo is required to increase, the pulse train UP is fed to the terminal 433 and no pulses DN are fed. During the pulse UP being high, the FETs 429 and 427 are on and off, respectively. The reference current Iref is flowing in the series-connected FETs 411 and 413. The voltage difference (Vn-Vo) is amplified by the amplifier 425 and its amplified output voltage Vgso is fed to the gate of the FET 419 via the on-FET 433. In response to the voltage Vgso, current Iso flows in the FET 419. The current Iso is mirrored current of the reference current Iref. The current Iso is sourced to the filter 449 and charges the capacitor thereof. Therefore, the output voltage Vo increases during the pulse UP being high.

The amplifier 425 detects the voltage difference (Vn-Vo) in the current-source mode. The negative feedback provided by the amplifier 425 guarantees that the voltage Vn is equal to the voltage Vo. The drain-source voltage of the FET 411 is equal to that of the FET 419. Hence, the current Iso flowing in the FET 419 is equal to the current Iref flowing in the FET 411.

(iii) Float Mode

In the float mode where no pulses are presented at the terminals 433 and 445. Because the pulse UP is low, the FETs 427 and 429 are on and off, respectively. Because the pulse DN is low, the FETs 439 and 441 are off and on, respectively. The voltage Vdd is fed to the gate of the FET 419 via the on-FET 427 and the ground potential is fed to the gate of the FET 421 via the on-FET 441. The FETs 419 and 421 are off and no current flows in the series-connected FETs 419 and 421. Neither current-sourcing to nor current-sinking from the filter 449 takes place. The voltage Vo depends upon the charge previously occurred in the filter 449.

In a case where the W/L ratios of the FETs 419 and 421 are X times of those of the FETs 411 and 413, respectively, and the $R_{423}$ is X time of $R_{415}$, the current Iso and Isi are X times (proportional) of the current Ipr. In order to provide the sink and source currents Isi and Iso of 1 mA, with the primary current Ipr of 100 µA, examples are:

| $R_{415}$ | 1 kΩ |
|---|---|
| FET 413 | W/L = 10/1 |
| FET 411 | W/L = 15/1 |
| Vref | 100 mV |
| $R_{423}$ | 100 Ω |
| FET 421 | W/L = 100/1 |
| FET 419 | W/L = 150/1 |

III-3. Second Embodiment

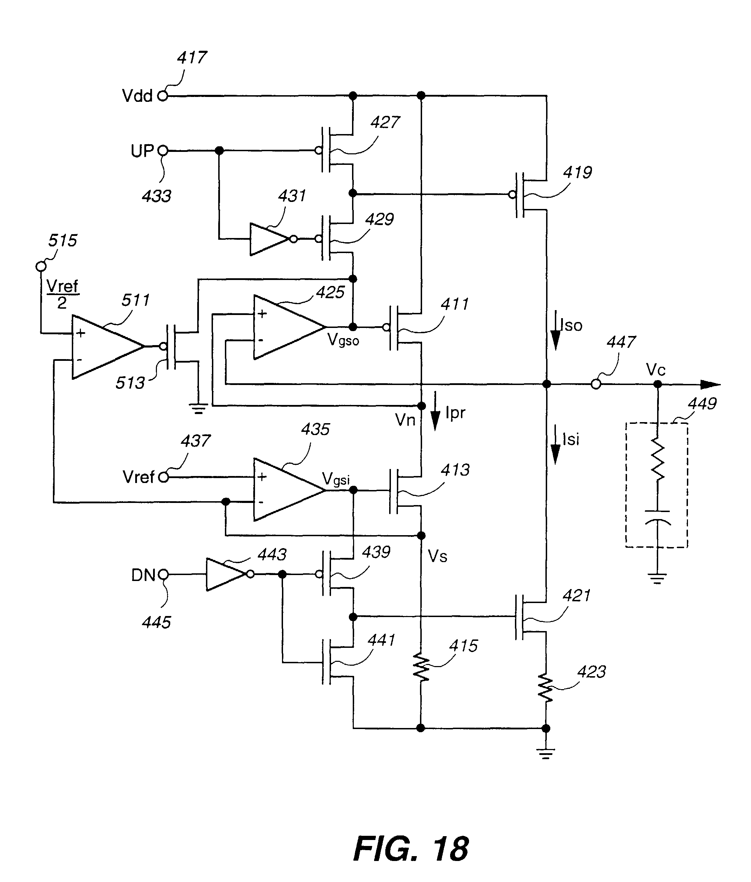

Figure 18 shows a CP circuit according to another embodiment of the present invention. The CP circuit further includes a start-up circuit of a comparator 511 and a FET 513. The non-inverting input terminal of the comparator 511 is connected to a voltage terminal 515 of a half reference voltage Vref/2. The inverting input terminal of the comparator 511 is connected to the inverting input terminal of the amplifier 435. The output terminal of the comparator 511 is connected to the gate of the FET 513, the source and drain of which are connected to the drain of the FET 429 and the ground terminal, respectively.

When the CP circuit is first turned on, the voltages Vn and Vo are zero. The amplifier 425 may not turn on the FET 411 with a zero differential voltage at its inputs. When the voltages Vn and Vo are zero, the voltage Vs across the resistor 415 is also zero. The output voltage of the comparator 511 is high, so that the FET 513 is turned on. The gate of the FET 411 is pulled to the ground potential and is turned on. Also, the FET 513 is turned on by the output voltage of the amplifier 435 and current flows in the on-FETs 411 and 413. In response to the up pulses UP from the PFC, the FET 419 sources current Iso to the output filter 449, with the result that the output voltage Vo increases. The start-up circuit ensures that the CP circuit starts properly and achieves the normal operating conditions. Under the normal conditions, the voltage Vs across the resistor 415 is Vref and thus, the comparator's output is low. The start-up circuit does not affect the operation of the CP circuit.

Although particular embodiments of the present invention have been described in detail, it should be appreciated that numerous variations, modifications, and adaptations may be made without departing from the scope of the present invention as defined in the claims.

**Claims**

1. A phase-locked loop (PLL) frequency synthesizer for providing a frequency controlled output signal which is phase-locked with a reference signal, the synthesizer comprising:

   oscillation means for generating the output signal in response to voltage of a frequency control signal fed thereto;
   first division means for dividing the frequency of the reference signal by a first division ratio and providing a first frequency divided signal, the first division ratio being set in a first mode and decreased in a second mode;
   second division means for dividing the frequency of the output signal of the oscillation means by a second division ratio and providing a second frequency divided signal, the second division ratio being set in the first mode and decreased in the second mode; and

voltage means for generating the frequency control signal in response to the difference in the phase/frequency between the first and second frequency divided signals, the frequency control signal being fed to the oscillation means, so that the frequency of the output signal is varied and the output signal is phase-locked with the reference signal.

**2.** The synthesizer of claim 1, wherein the first and second division means vary the first and second division ratios by the same factor upon change of mode.

**3.** The synthesizer of claim 2, wherein the first and second division ratios are varied at the same time.

**4.** The synthesizer of claim 1, wherein the voltage means comprises means for generating a current signal in response to the difference in the phase/frequency between the first and second frequency divided signals and means for converting the current signal to a voltage signal to provide the frequency control signal.

**5.** A multi-modulus frequency divider comprising:

a dual-modulus counter responsive to an input signal and for providing an output, the dual-modulus counter dividing the frequency of the input signal by either of division ratios P and P+1, P+1 being a power of two, the output having a divided frequency;

binary counting means responsive to the output from the dual-modulus counter, the binary counting means providing binary data representing the counting status thereof;

data comparison means for comparing binary data representing an input division ratio to the binary data representing the counting status of the binary counting means; and

selection means for selecting the division ratio of the dual-modulus counter in response to the comparison result of the data comparison means.

**6.** The multi-modulus frequency divider of claim 5, wherein the binary counting means comprises m-bit binary counter providing m-bit binary data representing the counting status.

**7.** The multi-modulus frequency divider of claim 6, wherein the data comparison means comprise:

means for separating the binary data of the input division ratio into first binary data of m-bits representing a first value and second binary data of k-bits representing a second value; and

complement means for providing complements of the second binary data.

**8.** The multi-modulus frequency divider of claim 7, wherein the data comparison means further comprises:

first comparison means for comparing the m-bit binary data representing the counting status to the first binary data of m-bits representing the first value; and

second comparison means for comparing k least significant bits of the m-bit binary data representing the counting status to the complements of the second binary data.

**9.** The multi-modulus frequency divider of claim 8, wherein the selection means comprises response means for determining the division ratio of the dual-modulus counter from the first and second division ratios in response to the comparison result of the data comparison means.

**10.** The multi-modulus frequency divider of claim 9, wherein the response means comprises a flip-flop for choosing either of the first and second division ratio.

**11.** The multi-modulus frequency divider of claim 7, wherein the complement means comprises a plurality of inverters.

**12.** The multi-modulus frequency divider of claim 8, wherein each of the first and second comparison means comprises a plurality of exclusive NOR gates.

**13.** The multi-modulus frequency divider of claim 12, further comprising an AND gate for providing an AND output from the outputs of the exclusive NOR gates.

**14.** The multi-modulus frequency divider of claim 9, wherein the response means comprises timing means for determining the timing of the selection of the division ratio for the dual-modulus counter.

**15.** The multi-modulus frequency divider of claim 14, wherein the timing means comprises:

a first flip-flop clocked by the output of the dual-modulus counter; and
first logic means for logically combining the outputs of the flip-flop and the data comparison means to generate a logic signal which determines the timing of the selection of the division ratio for the dual-modulus counter.

**16.** The multi-modulus frequency divider of claim 14, wherein the timing means comprises:

second and third flip-flops clocked by the output of the dual-modulus counter; and
second logic means for logically combining the outputs of the second and third flip-flops and the data comparison means to generate a logic signal which determines the timing of the selection of the division ratio for the dual-modulus counter.

**17.** The multi-modulus frequency divider of claim 14, wherein the second logic means comprises an AND gate for receiving the output of the third flip-flop and an additional bit signal.

**18.** The multi-modulus frequency divider of claim 17, wherein the additional bit signal comprises a single bit signal.

**19.** The multi-modulus frequency divider of claim 8, wherein the comparison result of the second comparison means synchronously resets the m-bit binary counter.

**20.** The multi-modulus frequency divider of claim 16, wherein the comparison result of the second comparison means is provided to the timing means and is provided as the output of the multi-modulus frequency divider.

**21.** The multi-modulus frequency divider of claim 16, wherein:

the third flip-flop is a D type one;
the comparison result of the second comparison means is provided to the D input of the third flip-flop, the output of which is provided as the output of the multi-modulus frequency divider and asynchronously reset the m-bit binary counter.

**22.** The multi-modulus frequency divider of claim 21, wherein the output of the third flip-flop asynchronously reset the m-bit binary counter to count 1.

**23.** The multi-modulus frequency divider of claim 6, wherein the dual-modulus counter is constructed with bipolar transistor devices and the m-bit binary counter is constructed with CMOS devices.

**24.** The multi-modulus frequency divider of claim 23, wherein the bipolar transistor devices and the CMOS devices are implemented in a BiCMOS circuit.

**25.** A charge pump circuit comprising a current mirror for sourcing current to and sinking current from an external circuit and control means for controlling current flowing in the current mirror,

the current mirror comprising:
first transistor means comprising first and second transistors, each having an input control electrode and other two electrodes, the other two electrodes of both transistors being connected in series; and
second transistor means comprising third and fourth transistors, each having an input control electrode and other two electrodes, the other two electrodes of both transistors being connected in series, the second transistor means sourcing current to and sinking current from the external circuit,
the control means comprising:
first transistor control means for providing a first signal to the input control electrode of the first transistor in response to a difference between first and second voltages from the first and second transistor means;
second transistor control means for providing a second signal to the input control electrode of the second transistor in response to a reference voltage; and
signal input means for feeding the first and second signals to the input control electrodes of the third and fourth transistors in response to a control signal.

26. The charge pump circuit of claim 25, wherein the first transistor control means comprises first feedback means for receiving the first and second voltages from the first and second transistor means, respectively, and for providing the first signal, so that the first and/or second voltage is variably controlled to match each other, in response to the first signal.

27. The charge pump circuit of claim 26, wherein the first feedback means comprises an operational amplifier having non-inverting and inverting input terminals for receiving the first and second voltages.

28. The charge pump circuit of claim 27, wherein the non-inverting input terminal is connected to the junction of the first and second transistors for receiving the first voltage and the inverting input terminal is connected to the junction of the third and fourth transistors for receiving the second voltage.

29. The charge pump circuit of claim 28, wherein the operational amplifier provides the first signal which is proportional to the voltage difference between the first and second voltages.

30. The charge pump circuit of claim 25, wherein the second transistor control means comprises second feedback means for receiving the reference voltage and a third voltage responding to the first voltage and for providing the second signal, so that the third voltage is variably controlled to match the reference voltage, in response to the second signal.

31. The charge pump circuit of claim 25, wherein the first transistor means comprises sense means connected in series to the first and second transistors to provide the third voltage.

32. The charge pump circuit of claim 31, wherein the second feedback means comprises an operational amplifier having non-inverting and inverting input terminals for receiving the reference and third voltages.

33. The charge pump circuit of claim 32, wherein the sense means comprises a resistance element.

34. The charge pump circuit of claim 25, wherein the signal input means comprises first and second feeding means for feeding the first and second signals to the third and fourth transistors, respectively, in response to first and second control signals.

35. The charge pump circuit of claim 34, wherein the first feeding means comprises first on-off means for causing the third transistor to be on and off in response to the first control signal.

36. The charge pump circuit of claim 34, wherein the second feeding means comprises second on-off means for causing the fourth transistor to be on and off in response to the second control signal.

37. The charge pump circuit of claim 25, further comprising start-up means for initializing the first transistor means so that a start-up current flows therein.

38. The charge pump circuit of claim 37, wherein the start-up means comprises turn-on means for turning-on the first transistor to initialize the first transistor means.

39. The charge pump circuit of claim 38, wherein the turn-on means comprises means for providing a turn-on signal in response to the voltage difference between a start reference voltage and the first voltage of the first transistor means.

40. The charge pump circuit of claim 25, wherein the first and third transistors are FETs of a first channel type and the second and fourth transistors are FETs of a second channel type.

41. The charge pump circuit of claim 40, wherein the first and second channel types are P- and N-channels.

42. The charge pump circuit of claim 40, wherein the FETs are metal oxide semiconductor transistors.

43. The charge pump circuit of claim 34, wherein the first control signal is fed in a current source mode.

**44.** The charge pump circuit of claim 34, wherein the second control signal is fed in a current-sink mode.

*121*

÷N

fo

*111*

÷R

fr

*113*

P/F
Detector

*115*

Charge
Pump

Icp
(In, Im)

*117*

Filter
F(s)

*119*

VCO

## FIG. 1

G
[dB]

G

W

f [log scale]

## FIG. 2

In

Im

## FIG. 3

R
(R0-R4)

Smx

N
(N0-N5)

↓ 5

↓ 6

*131*

*135*

Sr
fr →

| Programmable Dual-Modulus Divider R, R/4 | → ← | Programmable Dual-Modulus Divider N, N/4 | ← | So fo |

Sod
fod

So
fo

Srd frd

*133*

*137*

*139*

*141*

| P/F Detector | F, S → | Charge Pump | Icp (In, Im) → | F(s) | Vc → | VCO |

**FIG. 4**

**FIG. 5**

**FIG. 6**

**FIG. 7**

**FIG. 8**

**FIG. 9**

**FIG. 10**

In

Im

FIG. 11

**FIG. 12**

In1

In2

Out

## FIG. 13

| | |
|---|---|
| 0 | |
| 1 | |
| 2 | |
| . | |
| . | P count, $2^k$-K times |
| $2^k$-K-1 | |
| $2^k$-K | |
| . | |
| . | |
| . | |
| M | |
| 0 | |
| . | |

One divider cycle
M+1

## FIG. 14

**FIG. 15**

**FIG. 16**

**FIG. 17**

**FIG. 18**